# EUROPÄISCHE PATENTSCHRIFT

(11) **EP 3 385 771 B1**
(45) Veröffentlichungstag und Bekanntmachung des Hinweises auf die Patenterteilung: **25.10.2023**
(21) Anmeldenummer: 17165006.2
(22) Anmeldetag: 05.04.2017
(51) Int. Cl.: H01J 37/20, G02B 21/26, G02B 21/34

(54) **HALTEVORRICHTUNG FÜR PROBENTRÄGER UND VERFAHREN ZUM EIN- UND AUSBRINGEN EINES PROBENTRÄGERS**
HOLDING DEVICE FOR A SAMPLE HOLDER AND METHOD FOR INTRODUCING AND REMOVING OF A SAMPLE HOLDER
DISPOSITIF DE RETENUE POUR DES PORTE-ÉCHANTILLONS ET PROCÉDÉ D'INSERTION ET DE RETRAIT D'UN PORTE-ÉCHANTILLONS

(43) Veröffentlichungstag der Anmeldung: 10.10.2018
(73) Patentinhaber: Leica Mikrosysteme GmbH, 1170 Wien (AT)
(72) Erfinder: Lihl, Reinhard, 1120 Wien (AT); Gächter, Leander, 9463 Oberriet SG (CH); Mimietz-Oeckler, Saskia, 1170 Wien (AT)
(74) Vertreter: DehnsGermany Partnerschaft von Patentanwälten

(56) Entgegenhaltungen:
- EP-A1- 1 171 761
- CN-A- 103 196 404
- DE-U1- 8 019 943
- US-A- 2 120 404
- US-A1- 2002 131 167
- US-A1- 2003 138 353
- US-A1- 2007 122 834
- US-A1- 2007 128 071
- US-A1- 2017 160 532

## Beschreibung

Die vorliegende Erfindung betrifft eine Haltevorrichtung für Probenträger zur Verwendung in der Kryo-Mikroskopie sowie Verfahren zum Ein- und Ausbringen eines Probenträgers in eine solche Haltevorrichtung bzw. aus einer solchen Haltevorrichtung.

### Stand der Technik

Die Kryofixierung ist ein in der Elektronenmikroskopie häufig eingesetztes Probenpräparationsverfahren. Dabei wird eine wasserhaltige Probe sehr rasch auf eine Temperatur von unter -150°C eingefroren (kryofixiert), d.h. sie wird zur Vermeidung der Bildung von Eiskristallen sehr schnell abgekühlt. Die Kryofixierung hat sich als besonders geeignet für strukturbiologische Untersuchungen erwiesen. Die zu untersuchenden Objekte, beispielsweise Zellen, Enzyme, Viren oder Lipidschichten, werden dadurch in einer dünnen, vitrifizierten Eisschicht eingebettet. Der große Vorteil der Kryofixierung liegt darin, dass die biologischen Strukturen in ihrem nativen Zustand erhalten werden können. Unter anderem kann ein biologischer Vorgang zu einem beliebigen Zeitpunkt durch Kryofixierung angehalten und in diesem vitrifizierten Zustand untersucht werden, z.B. im Kryo-Elektronenmikroskop aber auch in einem Lichtmikroskop mit entsprechender Probenkühlung, wobei die Kryo-Lichtmikroskopie vor allem zum Auffinden von relevanten Bereichen in der Probe dient, welche Bereiche vorgemerkt und anschließend in einem Kryo-Elektronenmikroskop genauer betrachtet werden. Ein geeignetes Lichtmikroskop hierzu ist beispielsweise aus der WO 2016/016000 A1 bekannt.

Die gefrorenen Proben, die sich in aller Regel auf einem an sich bekannten elektronenmikroskopischen Probenträger, wie beispielsweise einem Netzchen/Grid oder einem Stift für die Rasterelektronenmikroskopie befinden, müssen unter den genannten tiefkalten Bedingungen und unter Ausschluss von Wasser in entsprechende Probenträgerfassungen bzw. Haltevorrichtungen verbracht werden, welche in der Folge in passende Halterungen in den genannten Mikroskopen verbracht werden können. Eine typische Probenträgerfassung für die Verwendung im Zusammenhang mit der vorliegenden Erfindung ist beispielsweise aus dem Dokument US 8 395 130 B2 bekannt geworden, bei welcher ein Netzchen, welches als Probenträger die tiefkalte Probe trägt, mit Klammerelementen in einer entsprechenden Fassung fixiert werden kann.

Um die Qualität der gefrorenen Proben nicht zu beeinträchtigen, ist es von großer Bedeutung, dass sie gekühlt und kontaminationsfrei zwischen den zum Einsatz kommenden Bearbeitungsgeräten, wie z.B. Kryofixiereinrichtung, Gefrierbruchvorrichtung, Beschichtungsvorrichtung bzw. Analysegeräten und hier vor allem Kryo-Lichtmikroskop und Kryo-Elektronenmikroskop, transferiert werden. Aus der DE 10 2014 110 724 B4 ist hierzu ein Manipulationsbehälter bekannt, in dem ein Halter für eine Probenträgerfassung verschiebbar ist.

Aus DE 80 19 943 U1 ist ein Objekthalter für diverse Mikroskope zur Aufnahme von Objekten mit unterschiedlichen Abmessungen bekannt, wobei der Objekthalter im Wesentlichen aus zwei gegeneinander verschiebbar gelagerten Platten besteht, deren einander gegenüberliegende Seiten mit Abstufungen zum Aufsetzen der Proben versehene Einbuchtungen besitzen, die sich zu einer durch Verschieben der Platten in ihren Abmessungen veränderlichen Öffnung ergänzen.

Aus der US 2002/0131167 A1 ist ein Probenhalter zur Verwendung in einem System zur Abbildung einer Probe bekannt. Der Probenhalter umfasst einen Tischkontakt zur Kontaktierung eines Tisches. Das Probenhaltungselement hält die durch das System abzubildende Probe. Ein oder mehrere Einstellmechanismen zur Einstellung der Position des Probehalteelements relativ zu dem Tisch sind vorgesehen.

Die US 2017/0160532 A1 und die CN 103 196 404 A offenbaren jeweils eine Haltevorrichtung, bei der zwei Schienen vorgesehen sind, in die ein plättchenförmiger Probenträger eingeschoben werden kann.

Mit den bekannten Haltevorrichtungen für Probenträger gestaltet sich jedoch die Handhabung der Probenträger, insbesondere wenn die Haltevorrichtung in einen Manipulationsbehälter eingebracht ist, schwierig, da insbesondere die Zugänglichkeit stark eingeschränkt ist.

Der Erfindung liegt daher die Aufgabe zu Grunde, eine Möglichkeit zum Halten von Probenträgern insbesondere für die Kryo-Mikroskopie zur Verfügung zustellen, die eine einfache Handhabung der Probenträger ermöglicht, insbesondere auch bei in einen Manipulationsbehälter eingebrachtem Zustand.

### Offenbarung der Erfindung

Erfindungsgemäß werden eine Haltevorrichtung für Probenträger, eine Anordnung und Verfahren zum Ein- bzw. Ausbringen von Probenträgern mit den Merkmalen der unabhängigen Patentansprüche vorgeschlagen. Vorteilhafte Ausgestaltungen sind Gegenstand der Unteransprüche sowie der nachfolgenden Beschreibung.

Eine erfindungsgemäße Haltevorrichtung für Probenträger dient zur Verwendung in der Kryo-Mikroskopie, also insbesondere auch mit den eingangs erwähnten Kyro-Elektronenmikroskopen und Kyro-Lichtmikroskopen, dort insbesondere jeweils in in einen Manipulationsbehälter eingebrachtem Zustand. Bei den Probenträgern kann es sich dabei insbesondere um Netzchen bzw. Grids handeln, die in eine Fassung eingebracht sind. Auf dem Netzchen bzw. Grid kann dann eine zu untersuchende Probe aufgebracht sein bzw. werden.

Die Haltevorrichtung weist nun einen Körper auf, der wenigstens eine Probenträger-Aufnahme mit wenigstens einer Probenträger-Auflagefläche aufweist, auf der wenigstens ein Probenträger anlegbar ist. Wenn ein Probenträger an der Probenträger-Aufnahme und damit insbesondere am Körper anliegt, kann eine gute Wärmeübertragung erreicht werden, was der Abkühlung gerade im gewünschten Kryo-Bereich zuträglich ist. Bevorzugt ist es, wenn wenigstens zwei Probenträger-Aufnahmen vorgesehen sind, also wenigstens Probenträger an jeweils einer entsprechenden Probenträger-Auflagefläche anlegbar sind, insbesondere nebeneinander, da dann der Platz deutlich besser ausgenutzt werden kann. Weiterhin weist die Haltevorrichtung wenigstens ein erstes Probenträger-Haltemittel und wenigstens ein zweites Probenträger-Haltemittel auf. Das wenigstens eine zweite Probenträger-Haltemittel, das dazu eingerichtet ist, den Probenträger gegen das erste Probenträger-Haltemittel mit Kraft zu beaufschlagen. Erfindungsgemäß weist das wenigstens eine erste Probenträger-Haltemittel eine erste Ausnehmung in Form eines Hinterschnitts auf, in das der Probenträger teilweise einbringbar ist. Dies ermöglicht eine einfache Herstellung der Haltevorrichtung bei gleichzeitiger Gewährleistung eines sicheren Halts und einfachen Einbringens eines Probenträgers.Bevorzugt kann das wenigstens eine zweite Probenträger-Haltemittel auch noch dazu eingerichtet sein, bei einer Positionierung des Probenträgers weg von dem wenigstens einen ersten Probenträger-Haltemittel gedrückt zu werden, also insbesondere unter externer Kraftaufbringung.

Vorzugsweise kann das wenigstens eine erste Probenträger-Haltemittel dabei durch wenigstens einen Teil einer Innenwandung der Probenträger-Aufnahme ausgebildet sein, d.h. der Probenträger wird vom zweiten Probenträger-Haltemittel dann gegen die Innenwandung der Probenträger-Aufnahme mit Kraft beaufschlagt bzw. gedrückt. Dies ermöglicht eine besonders kompakte und stabile Bauart. Insbesondere gibt es weniger Bauteile, die möglicherweise bei tiefkalten Temperaturen einer Degradation bzw. Materialermüdung unterliegen könnten.

Mit einer solchen Haltevorrichtung können nun Probenträger nicht nur sicher gehalten werden, sondern auch einfach in die Haltevorrichtung eingebracht und auch wieder daraus ausgebracht werden, insbesondere auch unter Verwendung eines Greifwerkzeugs wie einer Pinzette. Die zusammengehörigen ersten und zweiten Haltemittel bewirken dabei eine Art Klemmung des Probenträgers in der Haltevorrichtung. Erfindungsgemäß wird der Probenträger dabei auch gegen die Probenträger-Auflagefläche gedrückt, und zwar durch das erste Probenträger-Haltemittel und das zweite Probenträger-Haltemittel. Hierzu sind das erste bzw. zweite Probenträger-Haltmittel entsprechend ausgebildet, wie später noch detaillierter erläutert wird.

Wenn das erste Probenträger-Haltemittel durch wenigstens einen Teil der Innenwandung der Probenträger-Aufnahme gebildet wird, ist dies insbesondere ortsfest, während das andere beweglich ausgebildet ist, d.h. es wird nicht nur eine einfache und stabile Konstruktion, sondern auch das besonders einfache Ein- und Ausbringen von Probenträgern begünstigt. Da der Probenträger oder eine Fassung als Teil des Probenträgers an der Probenträger-Auflagefläche anliegt, ist auch eine gute Wärmeübertragung möglich.

Vorzugsweise umfasst das wenigstens eine erste Haltemittel einen Vorsprung, dessen Innenfläche wenigstens teilweise als Probenträger-Anlagefläche dient. Ein solcher Vorsprung oder ein Endpunkt oder eine Kante davon, kann dabei über der Probenträger-Aufnahmefläche liegen. Damit kann erreicht werden, dass der Probenträger, wenn er an dem ersten Probenträger-Haltemittel bzw. der Probenträger-Anlagefläche anliegt, gegen die Probenträger-Auflagefläche gedrückt und damit stabiler gehalten wird.

Es ist von Vorteil, wenn das wenigstens eine zweite Probenträger-Haltemittel eine Feder, insbesondere eine Blattfeder, aufweist. Eine Feder stellt ein besonders einfaches Bauteil dar, mit dem eine ausreichend hohe Kraftbeaufschlagung eines Probenträgers sichergestellt werden kann. Dies gilt insbesondere für eine Blattfeder, die zudem auch unter tiefkalten Temperaturen keiner oder zumindest kaum einer Funktionseinschränkung unterliegt. Eine solche Blattfeder kann dabei auch sehr einfach an dem Körper angebracht werden, beispielsweise mittels einer Schraube. Für den Fall, dass die Haltevorrichtung zur gleichzeitigen Aufnahme mehrerer Probenträger ausgebildet ist, also mehrere Probenträger-Aufnahmen umfasst, können auch mehrere Blattfedern aus einem einzigen Bauteil, also insbesondere einem einzigen flachen Blech hergestellt sein, wodurch die Anbringung am Körper vereinfacht wird.

Vorteilhafterweise ist in dem Körper wenigstens eine zweite Ausnehmung vorgesehen, die derart ausgebildet ist, dass mittels eines Greifwerkzeugs, beispielsweise einer geeigneten Pinzette oder dergleichen, ein an der Probenträger-Auflagefläche anliegender Probenträger greifbar ist. Zweckmäßig ist es dann, wenn das wenigstens eine erste Probenträger-Haltemittel zwei Abschnitte aufweist, die seitlich der zweiten Ausnehmung in dem Körper angeordnet sind, da dann eine gleichmäßige Klemmung der Probenträger möglich ist. Durch eine solche zweite Ausnehmung kann ein Probenträger dann einerseits solange mittels des Greifwerkzeugs gehalten werden, bis er beim Einbringen an der Probenträger-Auflagefläche anliegt bzw. die Endposition erreicht hat. Andererseits kann der Probenträger aber auch zum Herausnehmen mit dem Greifwerkzeug sehr einfach umgriffen werden, um ihn sicher mit dem Greifwerkzeug festzuhalten.

Es ist von Vorteil, wenn die Haltevorrichtung derart ausgebildet ist, dass sie sich in einer Richtung senkrecht zur Probenträger-Aufnahmefläche in Richtung eines anliegenden Probenträgers höchstens um ein einer Dicke (in der Richtung senkrecht zur Probenträger-Auflagefläche) des Probenträgers entsprechendes Maß erstreckt. Mit anderen Worten überragt die Haltevorrichtung nicht, also insbesondere auch keine ihrer Komponenten wie die ersten und zweiten Probenträger-Haltemittel oder die Probenträger-Aufnahme, einen eingebrachten Probenträger. Damit kann eine sicherere Handhabung beim Ein- und Ausbringen der Probenträger erreicht werden. Zudem kann auf diese Weise beispielsweise ein Objektiv eines Mikroskops näher bzw. besser an die Probenträger herangeführt werden.

Vorzugsweise ist die wenigstens eine Probenträger-Aufnahme derart ausgebildet, dass der jeweilige Probenträger, wenn er an der Probenträger-Auflagefläche anliegt, mit wenigstens 10%, bevorzugt wenigstens 20%, besonders bevorzugt wenigstens 40%, einer der Probenträger-Auflagefläche zugewandten Fläche anliegt. Zusätzlich oder alternativ ist die wenigstens eine Probenträger-Aufnahme derart ausgebildet, dass eine Fassung des jeweiligen Probenträgers, wenn sie an der Probenträger-Auflagefläche anliegt, mit wenigstens 20%, bevorzugt wenigstens 40%, besonders bevorzugt wenigstens 60%, denkbar sind aber auch wenigstens 70% oder wenigstens 80%, einer der Probenträger-Auflagefläche zugewandten Fläche anliegt. Damit kann eine besonders gute Wärmeübertragung und damit eine besonders gute und effektive Kühlung der Probenträger und damit der darauf angeordneten Proben erreicht werden.

Besonders bevorzugt ist es, wenn die Haltevorrichtung zur Verwendung mit ringförmigen Probenträgern ausgebildet ist. Solche ringförmige Probenträger können dabei insbesondere eine ringförmige Fassung aufweisen. In diesem Fall ist insbesondere bei den ersten Probenträger-Haltemitteln darauf zu achten, dass diese möglichst gut an die äußere Form der Probenträger angepasst sind. Im Falle von zwei Abschnitten eines ersten Probenträger-Haltemittels können diese beiden Abschnitte entsprechend auf einem Kreisumfang angeordnet sein. Für den bevorzugten Fall, dass die Probenträger-Aufnahme in Form einer Ausnehmung im Körper ausgebildet ist, , kann diese Ausnehmung bzw. die Probenträger-Aufnahme eine im Wesentlichen runde, auch elliptische oder ovale Form aufweisen, wobei eine gewisse Verschiebung des an der Probenträger-Auflagefläche anliegenden Probenträgers zwischen erstem und zweiten Probenträger-Haltemittel möglich sein sollte.

Vorzugsweise beträgt die größte Abmessung der Haltevorrichtung weniger als 50 mm, insbesondere weniger als 20 mm. Es versteht sich, dass die Abmessungen mindestens denjenigen der Probenträger entsprechen sollten. Probenträger, wie sie für die Kryo-Mikroskopie verwendet werden, sind in aller Regel verhältnismäßig klein. Im Falle ringförmiger Probenträger weisen diese - bei im Wesentlichen flacher Bauart - einen Durchmesser von meist nur wenigen Millimetern, beispielsweise 3 bis 5 mm auf. Gerade bei solch geringen Abmessungen gestaltet sich die Handhabung von Probenträgern sehr schwierig, insbesondere wenn die Handhabung in einem weitestgehend geschlossenen Manipulationsbehälter und bei tiefkalten Temperaturen erfolgen muss. Hier kommen die Vorteile der vorgeschlagenen Haltevorrichtung mit dem einfachen Ein- und Ausbringen von Probenträgern und deren sicherem Halten besonders gut zum Tragen.

Vorteilhafterweise ist eine Aufnahme für einen Manipulator zur Bewegung der Haltevorrichtung vorgesehen. Damit kann eine besonders einfache und sicherere Handhabung der Haltevorrichtung selbst erfolgen.

Gegenstand der Erfindung ist weiterhin eine Anordnung mit einem Manipulationsbehälter und einer erfindungsgemäßen Haltevorrichtung, bei der eine Aufnahme für einen Manipulator zur Bewegung der Haltevorrichtung vorgesehen ist. Der Manipulationsbehälter ist dabei derart ausgebildet, dass die Haltevorrichtung darin fixiert werden kann. Zudem ist ein Manipulator vorgesehen, auf den die Haltevorrichtung, insbesondere abnehmbar, aufbringbar ist und mit dem die Haltevorrichtung, insbesondere innerhalb des Manipulationsbehälters, bewegbar ist.

Hinsichtlich der Vorteile sei an dieser Stelle zur Vermeidung von Wiederholungen auf die vorstehenden Ausführungen zur Haltevorrichtung verwiesen, die hier entsprechend gelten.

Gegenstand der Erfindung ist weiterhin ein Verfahren zum Einbringen eines Probenhalters in eine erfindungsgemäße Haltevorrichtung. Hierzu wird der Probenträger mittels eines Greifwerkzeugs gegriffen und gegen ein zweites Probenträger-Haltemittel gedrückt, sodass dieses zweite Probenträger-Haltemittel weg von einem ersten Probenträger-Haltemittel gedrückt wird. Anschließend wird der Probenträger an der Probenträger-Auflagefläche angelegt und an das erste Probenträger-Haltemittels bis zu einem Anschlag an diesem bewegt. Dieses Vorgehen ermöglicht ein einfaches Einbringen eines Probenträgers in die Haltevorrichtung, wobei der Probenträger anschließend sicher in der Haltevorrichtung gehalten wird.

Gegenstand der Erfindung ist weiterhin ein Verfahren zum Ausbringen eines Probenhalters aus einer erfindungsgemäßen Haltevorrichtung. Hierzu wird der Probenträger mittels eines Greifwerkzeugs unter Drücken gegen ein zweites Probenträger-Haltemittel weg von einem ersten Probenträger-Haltemittel bewegt. Anschließend wird der Probenträger von der Probenträger-Auflagefläche weggehoben und aus der Haltevorrichtung ausgebracht. Dieses Vorgehen ermöglicht ein einfaches Ausbringen eines Probenträgers aus der Haltevorrichtung.

Hinsichtlich weiterer Vorteile der Verfahren sei an dieser Stelle zur Vermeidung von Wiederholungen auch auf obige Ausführungen zur Haltevorrichtung verwiesen.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

- Figur 1: zeigt schematisch eine erfindungsgemäße Haltevorrichtung in bevorzugter Ausführungsform in einer Explosionsdarstellung.
- Figur 2: zeigt die Haltevorrichtung aus Figur 1 in zusammengesetzter Darstellung mit eingesetztem Probenträger.
- Figur 3: zeigt einen vergrößerten Ausschnitt aus Figur 2.
- Figur 4: zeigt die Haltevorrichtung aus Figur 1 in Draufsicht.
- Figur 5: zeigt einen Teil der Haltevorrichtung aus Figur 4 vergrößert und in einer Schnittansicht.
- Figur 6: zeigt einen Teil des in Figur 5 gezeigten Ausschnitts.
- Figur 7: zeigt einen weiteren Teil der Haltevorrichtung aus Figur 4 vergrößert und in einer Schnittansicht.
- Figur 8: zeigt eine erfindungsgemäße Anordnung mit Manipulationsbehälter und Haltevorrichtung in bevorzugter Ausführungsform.
- Figur 9: zeigt einen Ablauf eines erfindungsgemäßen Verfahrens in bevorzugter Ausführungsform.

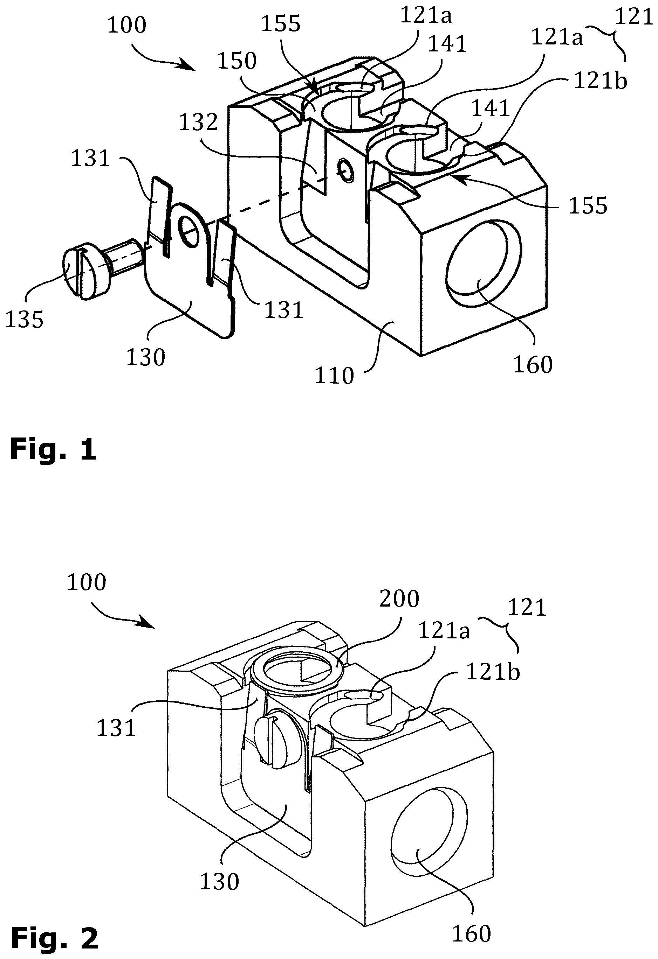

In den Figuren 1 bis 7 ist eine erfindungsgemäße Haltevorrichtung für Probenträger in bevorzugter Ausführungsform schematisch dargestellt. Im Folgenden soll diese Haltevorrichtung 100 übergreifend über die Figuren 1 bis 7 näher beschrieben werden.

Die Haltevorrichtung 100 weist einen Körper 110 auf, der hier - von verschiedenen Ausnehmungen und dergleichen abgesehen - eine im Wesentlichen quaderförmige äußere Form aufweist. Im Inneren kann die Haltevorrichtung 100 auch hohl sein bzw. Ausnehmungen aufweisen. Die Haltevorrichtung 100 ist beispielhaft zur Aufnahme von zwei Probenträgern 200, von denen in den Figuren 2 bis 5 jeweils einer zu sehen ist, vorgesehen und weist daher zwei Probenträger-Aufnahmen 155 auf.

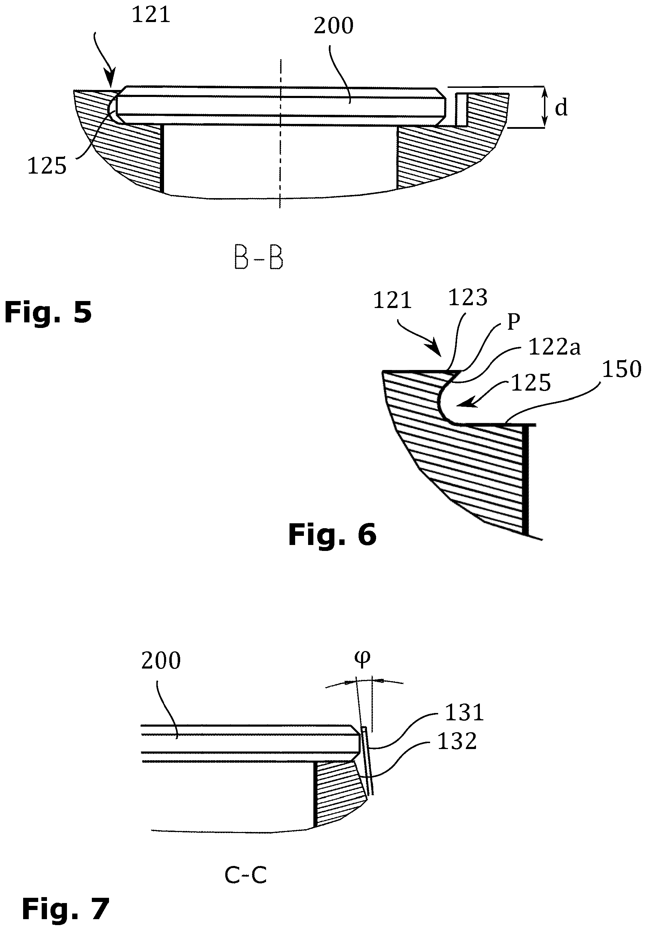

Weiterhin weist die Haltevorrichtung 100 zwei erste Probenträger-Haltemittel 121 auf, die hier durch einen Teil einer Innenwandung 122 der Probenträger-Aufnahme 155 gebildet sind und zudem insbesondere integral mit dem Körper 110 ausgebildet sind. Dabei sind die ersten Probenträger-Haltemittel 121 mit ersten Ausnehmungen 125 in Form von Hinterschnitten ausgebildet. Dies ist besonders deutlich in den Schnittansichten in den Figuren 5 und 6 zu sehen, wobei Figur 6 den linken Teil der Figur 5 zeigt, jedoch ohne anliegenden Probenträger.

Insbesondere weist das erste Probenträger-Haltemittel 121 hier einen Vorsprung 123 auf, dessen äußere Kante, hier mit P bezeichnet, über der Probenträger-Auflagefläche 150 liegt. Auf diese Weise wird hier eine Ausnehmung 125 gebildet, die auch bei anliegendem Probenträger zumindest teilweise frei bleibt. Der Probenträger 200 liegt also mit nur an einer Probenträger-Anlagefläche 122a, die hier Teil der Innenwandung 122 ist und im Bereich des Vorsprungs 123 vorgesehen ist, an. Auf diese Weise kann auch erreicht werden, dass der Probenträger 200 von dem ersten Probenträger-Haltemittel 121 derart gehalten wird, dass nicht nur eine Kraft bzw. Kraft-Komponente parallel zur Probenträger-Auflagefläche 150, sondern auch senkrecht dazu auf den Probenträger 200 wirkt. Der Probenträger 200 wird also durch das erste Probenträger-Haltemittel 121 auch auf die Probenträger-Auflagefläche 150 gedrückt bzw. an dieser angedrückt und somit auch vor einem Herausfallen, wenn die Haltevorrichtung beispielsweise gedreht wird, geschützt..

Zudem ist hierbei auch zu sehen, dass die Haltevorrichtung 100 den Probenträger 200 in ihrer Höhe nicht überragt, d.h. dass die Erstreckung der Haltevorrichtung 100 senkrecht zur Probenträger-Auflagefläche 150 nicht größer als die Dicke d des Probenträgers 200 ist, wie sie in Figur 5 gezeigt ist.

Die ersten Probenträger-Haltemittel 121 sind dabei zudem an die runde Form der Probenträger 200 angepasst. Insbesondere weisen die ersten Probenträger-Haltemittel 121 hier jeweils zwei Abschnitte 121a und 121b auf, die seitlich von einer zweiten Ausnehmung 141 angeordnet sind. In der zweiten Ausnehmung 141 kann beim Ein- bzw. Ausbringen von Probenträgern ein Greifwerkzeug Platz finden, wie später noch näher erläutert wird.

Weiterhin weist die Haltevorrichtung 100 zwei zweite Probenträger-Haltemittel 131 auf, die hier jeweils eine Feder, insbesondere eine Blattfeder aufweisen. Im gezeigten Fall sind die beiden Blattfedern 131 als Teil eines Bleches 130 ausgebildet. Hierzu kann ein solches Blech 130, das aus einem geeigneten, d.h. federnden, Material besteht, entsprechend ausgebildet werden.

In dem Blech 130 ist dabei ein Loch vorgesehen, sodass das Blech 130 und damit die beiden Blattfedern 131 mittels einer Schraube 135 an dem Körper 110 befestigt werden können. Es versteht sich, dass auch andere Befestigungsmittel verwendet werden können oder dass die Blattfedern einzeln befestigt werden können.

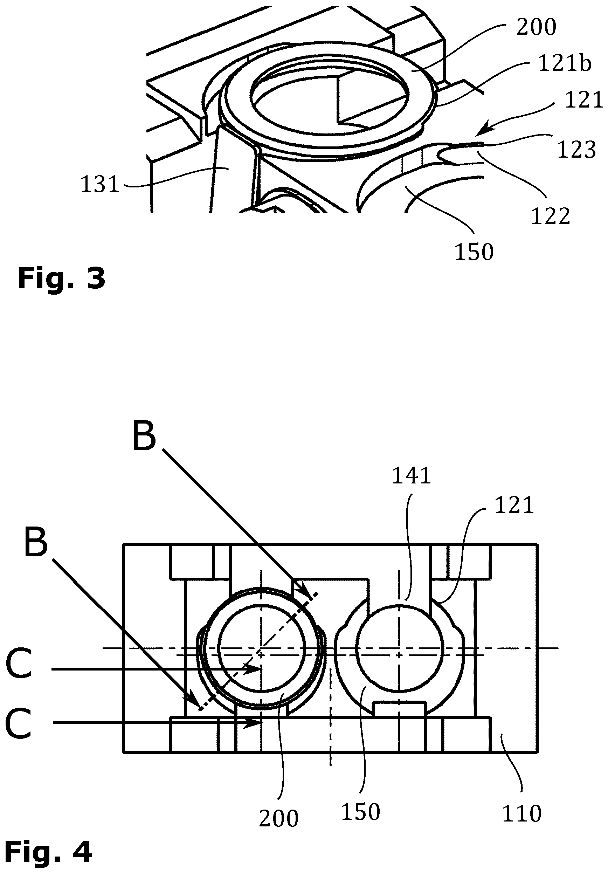

Anhand der Abbildung in Figur 1 und insbesondere auch in Figur 7 ist auch deutlich zu sehen, dass die Blattfedern 131 gegenüber dem Rest des Bleches 130 in Richtung der zweiten Haltemittel 121 verbogen sind, beispielsweise zwischen ca. 5° und 7°. In Figur 7 ist dies mit dem Winkel ϕ gezeigt. Im Körper 110 sind hierzu auch entsprechende Ausnehmungen 132 vorgesehen. Auf diese Weise können die Blattfedern 131 jeweils eine Kraft auf einen an der Probenträger-Auflagefläche 150 angelegten Probenträger 200 nicht nur mit einer Kraftkomponenten gegen das erste Probenträger-Haltemittels 121, sondern auch gegen die Probenträger-Auflagefläche 150 ausüben und so den jeweiligen Probenträger, wie in den Figuren 2 und 3 zu sehen, sicher festhalten.

Der Winkel, den die Blattfedern 131 mit dem Rest des Bleches 130 einschließen, kann bei eingebrachtem Probenträger insbesondere geringer sein als ohne eingebrachten Probenträger, sodass eine Kraftausübung bei eingebrachtem Probenträger gewährleistet wird. Der Probenträger kann auf diese Weise nicht nur mittels des ersten Probenträger-Haltemittels 121 sondern auch mittels des zweiten Probenträger-Haltemittels 131 gegen die Probenträger-Auflagefläche 150 gedrückt werden.

Zugleich kann die jeweilige Blattfeder 131 aber auch in eine Richtung weg von dem entsprechenden ersten Haltemittel 121 gedrückt werden, wenn eine entsprechende Kraft (von extern) auf die jeweilige Blattfeder 131 ausgeübt wird. Dies kann insbesondere bei einer Positionierung bzw. einem Einbringen eines Probenträgers, aber auch beim Ausbringen vorteilhaft sein.

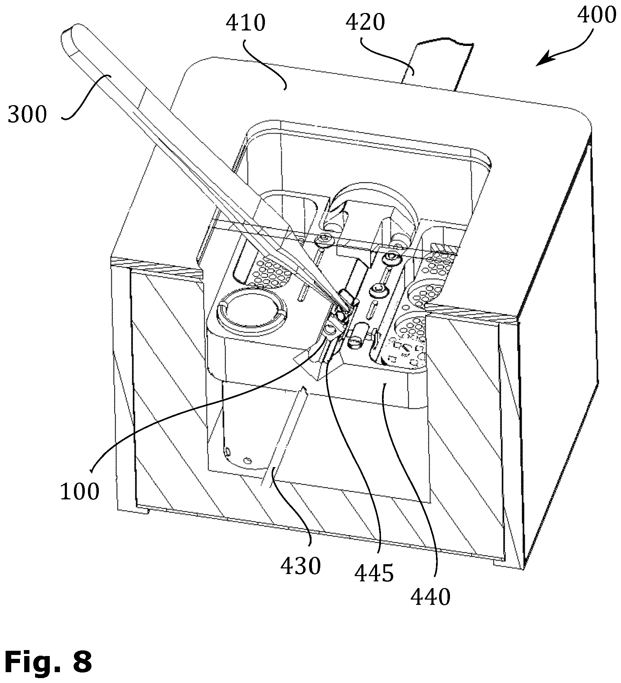

In Figur 8 ist eine Anordnung mit einem Manipulationsbehälter 400 und einer Haltevorrichtung 100 in bevorzugter Ausführungsform schematisch dargestellt. Der Manipulationsbehälter 400 weist eine Wandung 410 auf und kann beispielsweise mittels eines Griffes 420 gehalten und bewegt werden.

In dem Manipulationsbehälter 400 ist eine Manipulationshalterung 445 vorgesehen, die eine Führung 445 aufweist, in welcher die Haltevorrichtung 100 eingebracht und fixiert werden kann. Wenn die Haltevorrichtung fixiert ist, kann beispielsweise mittels eines Greifwerkzeugs 300, hier in Form einer Pinzette, ein Probenträger in die Haltevorrichtung 100 eingebracht oder aus der Haltevorrichtung 100 ausgebracht werden.

Weiterhin ist ein Manipulator 430 vorgesehen, der beispielsweise entlang einer Achse, in der beispielhaft auch der Griff 420 liegt, bewegt werden kann. Der Manipulator 430 kann dabei Teil der Manipulationsvorrichtung 400 sein. Der Manipulator 430 kann zudem beispielsweise an die Haltevorrichtung 100 herangebracht werden, sodass die Haltevorrichtung 100 mittels der Aufnahme 160, wie sie beispielsweise in den Figuren 1 und 2 zu sehen ist, an den Manipulator 430 angebracht werden kann. Damit kann die Haltevorrichtung 100 dann bewegt werden. Denkbar ist dabei auch, dass die Haltevorrichtung 100 durch eine geeignete Öffnung aus dem Manipulationsbehälter 400 herausgebracht bzw. in diesen eingebracht wird.

Es sei angemerkt, dass die Haltevorrichtung - je nach Situation sowohl einzeln als auch in dem Manipulationsbehälter befindlich - zwischen verschiedenen Geräten hin und her bewegt werden kann, um verschiedene Prozesse mit verschiedenen Geräten durchzuführen.

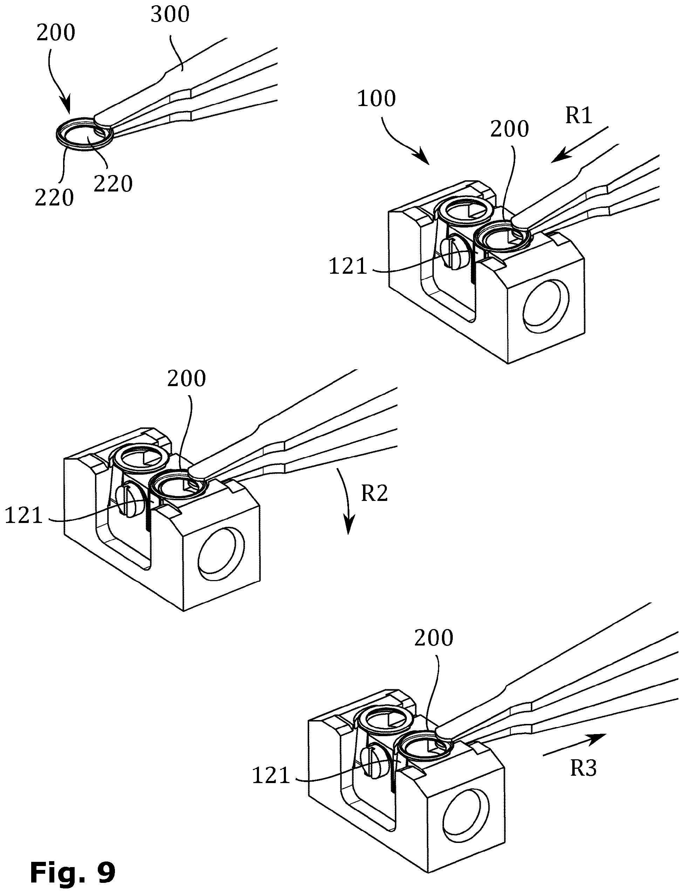

In Figur 9 ist ein Ablauf eines erfindungsgemäßen Verfahrens in bevorzugter Ausführungsform schematisch und anhand von vier Abbildungen von oben nach unten dargestellt. Zunächst kann ein Probenträger 200 mit einer Pinzette 300 gegriffen werden.

In der ersten Abbildung ist dabei auch zu sehen, dass der Probenträger 200 eine Fassung 210, die hier insbesondere ringförmig ausgebildet ist, und ein Netzchen bzw. ein Grid 220 aufweisen kann, wobei auf Letzteres eine Probe aufgebracht sein kann.

Wie in der zweiten Abbildung zu sehen, kann der Probenträger 200 dann in Richtung R1 mittels der Pinzette gegen die entsprechende Blattfeder 131 gedrückt werden. Dabei sollte der Probenträger schräg, beispielsweise unter einem Winkel von ca. 5°, gehalten werden, wie dies auch durch den schrägen Pfeil zu R1 angedeutet ist. Die Blattfeder 131 wird dabei etwas von dem ersten Haltemittel weggedrückt.

Anschließend kann, wie in der dritten Abbildung zu sehen ist, der Probenträger 200 in Richtung R2 abgesenkt, d.h. der Probenträger kann auf der Probenträger-Auflagefläche abgelegt werden. Die Pinzette findet dabei in der beispielsweise in Figur 1 gezeigten zweiten Ausnehmung 141 Platz. Dann kann, wie in der vierten Abbildung zu sehen, der Probenträger 200 an das erste Probenträger-Haltemittel, hier in Richtung R3, gezogen werden. Dabei entspannt sich die Blattfeder 131 etwas und der Probenträger wird in bzw. an das erste Probenträger-Haltemittel gedrückt. Durch die in bereits beschriebene, besondere Ausgestaltung des ersten und zweiten Probenträger-Haltemittels kann der Probenträger insbesondere auch auf die Probenträger-Auflagefläche gedrückt werden.

Der Probenträger ist auf diese Weise sicher in der Haltevorrichtung gehalten. Zum Entnehmen des Probenträgers 200 aus der Haltevorrichtung können die erwähnten Schritte in der umgekehrten Reihenfolge durchgeführt werden.

Wie anhand der Figuren ersichtlich ist, kann der Probenträger - zumindest bei der hier gezeigten Form - beidseitig in die Haltevorrichtung eingelegt werden. Es sollte jedoch darauf geachtet werden, dass diejenige Seite des Probenträgers nach oben, also von der Probenträger-Auflagefläche weg, weist, an welcher das Netzchen bzw. Grid angebracht ist. Auf diese Weise ist eine bessere Beobachtung mittels eines Mikroskops möglich.

## Patentansprüche

1. Haltevorrichtung (100) für Probenträger (200) zur Verwendung in der Kryo-Mikroskopie umfassend:
- einen Körper (110) mit wenigstens einer Probenträger-Aufnahme (155), die wenigstens eine Probenträger-Auflagefläche (150) aufweist, auf der wenigstens ein Probenträger (200) anlegbar ist,
- wenigstens ein erstes Probenträger-Haltemittel (121), und
- wenigstens ein zweites Probeträger-Haltemittel (131), das dazu eingerichtet ist, den Probenträger (200) gegen das erste Probenträger-Haltemittel (121) mit Kraft zu beaufschlagen,
wobei das wenigstens eine erste Probenträger-Haltemittel (121) wenigstens eine erste Ausnehmung (125), in Form eines Hinterschnitts aufweist, in die der Probenträger (200) teilweise einbringbar ist,
**dadurch gekennzeichnet, dass**
das wenigstens eine erste Probenträger-Haltemittel (121) und das wenigstens eine zweite Probenträger-Haltemittel (131) derart ausgebildet sind, dass der Probenträger (200), wenn er an dem ersten Probenträger-Haltemittel (121) und an dem zweiten Probenträger-Haltemittel (131) anliegt, durch das erste Probenträger-Haltemittel (121) und durch das zweite Probenträger-Haltemittel (131) gegen die Probenträger-Auflagefläche (150) gedrückt wird.

2. Haltevorrichtung (100) nach Anspruch 1, wobei das erste Probenträger-Haltemittel (121) durch wenigstens einen Teil einer Innenwandung (122) der Probenträger-Aufnahme ausgebildet ist.

3. Haltevorrichtung (100) nach Anspruch 1 oder 2, wobei das wenigstens eine erste Probeträger-Haltemittel (121) wenigstens einen Vorsprung (123) umfasst, dessen Innenfläche wenigstens teilweise als Probenträger-Anlagefläche (122a) dient.

4. Haltevorrichtung (100) nach einem der vorstehenden Ansprüche, wobei das wenigstens eine zweite Probenträger-Haltemittel (131) eine Feder, insbesondere eine Blattfeder, aufweist.

5. Haltevorrichtung (100) nach einem der vorstehenden Ansprüche, wobei in dem Körper (110) wenigstens eine zweite Ausnehmung (141) vorgesehen ist, die derart ausgebildet ist, dass mittels eines Greifwerkzeugs (300) ein an der Probenträger-Auflagefläche (150) anliegender Probenträger (200) greifbar ist.

6. Haltevorrichtung (100) nach Anspruch 5, wobei das wenigstens eine erste Probenträger-Haltemittel (121) wenigstens zwei Abschnitte (121a, 121b) aufweist, die seitlich der zweiten Ausnehmung (141) in dem Körper (110) ausgebildet sind.

7. Haltevorrichtung (100) nach einem der vorstehenden Ansprüche, die derart ausgebildet ist, dass sie sich in einer Richtung senkrecht zur Probenträger-Aufnahmefläche (150) in Richtung eines anliegenden Probenträgers (200) höchstens um ein einer Dicke (d) des Probenträgers (200) entsprechendes Maß erstreckt.

8. Haltevorrichtung (100) nach einem der vorstehenden Ansprüche, wobei die wenigstens eine Probenträger-Aufnahme (155) derart ausgebildet ist, dass der Probenträger (200), wenn er an der Probenträger-Auflagefläche (150) anliegt, mit wenigstens 10%, , einer der Probenträger-Auflagefläche (150) zugewandten Fläche anliegt, und/oder wobei die wenigstens eine Probenträger-Aufnahme (155) derart ausgebildet ist, dass eine Fassung (210) des Probenträgers (200), wenn sie an der Probenträger-Auflagefläche (150) anliegt, mit wenigstens 20% einer der Probenträger-Auflagefläche (150) zugewandten Fläche anliegt.

9. Haltevorrichtung (100) nach einem der vorstehenden Ansprüche, wobei das wenigstens eine zweite Probenträger-Haltemittel (131) dazu eingerichtet ist, bei einer Positionierung des Probenträgers (200) weg von dem wenigstens einen ersten Probenträger-Haltemittel (121) gedrückt zu werden.

10. Haltevorrichtung (100) nach einem der vorstehenden Ansprüche, die zur Verwendung mit ringförmigen Probenträgern (200) ausgebildet ist.

11. Haltevorrichtung (100) nach einem der vorstehenden Ansprüche, mit wenigstens zwei Probenträger-Aufnahmen (150).

12. Haltevorrichtung (100) nach einem der vorstehenden Ansprüche, deren größte Abmessung weniger als 50 mm, insbesondere weniger als 20 mm, beträgt.

13. Haltevorrichtung (100) nach einem der vorstehenden Ansprüche, wobei eine Aufnahme (160) für einen Manipulator (430) zur Bewegung der Haltevorrichtung (100) vorgesehen ist.

14. Anordnung mit einem Manipulationsbehälter (400) und einer Haltevorrichtung (100) nach Anspruch 13, wobei der Manipulationsbehälter (400) derart ausgebildet ist, dass die Haltevorrichtung (100) darin fixiert werden kann, und ein Manipulator (430) vorgesehen ist, auf den die Haltevorrichtung (100) aufbringbar ist und mit dem die Haltevorrichtung (100) bewegbar ist.

15. Verfahren zum Einbringen eines Probenträgers (200) in eine Haltevorrichtung (100) nach einem der Ansprüche 1 bis 13,
wobei der Probenträger (200) mittels eines Greifwerkzeugs (300) gegriffen und gegen ein zweites Haltemittel (131) gedrückt wird, sodass dieses zweite Haltemittel (131) weg von einem ersten Haltemittel (121) gedrückt wird, und
wobei der Probenträger (200) anschließend an die Probenträger-Auflagefläche (150) angelegt und an das erste Haltemittel (121) bis zu einem Anschlag an diesem bewegt wird.

16. Verfahren zum Ausbringen eines Probenträgers (200) aus einer Haltevorrichtung (100) nach einem der Ansprüche 1 bis 13,
wobei der Probenträger (200) mittels eines Greifwerkzeugs (300) unter Drücken gegen ein zweites Haltemittel (131) weg von einem ersten Haltemittel (121) bewegt wird, und
wobei anschließend der Probenträger (200) von der Probenträger-Auflagefläche (150) weggehoben und aus der Haltevorrichtung (100) ausgebracht wird.

## Claims

1. A holding device (100) for sample carriers (200) for use in cryo-microscopy comprising:
- a body (110) with at least one sample carrier receptacle (155) which has at least one sample carrier support surface (150) on which at least one sample carrier (200) can be placed,
- at least a first sample carrier holding means (121), and
- at least a second sample carrier holding means (131) adapted to apply force to the sample carrier (200) against the first sample carrier holding means (121),
wherein the at least one first sample carrier holding means (121) has at least one first recess (125), in the form of an undercut, into which the sample carrier (200) can be partially inserted,
**characterised in that** the at least one first sample carrier holding means (121) and the at least one second sample carrier holding means (131) are formed in such a way that the sample carrier (200), when it rests against the first sample carrier holding means (121) and against the second sample carrier holding means (131), is pressed against the sample carrier supporting surface (150) by the first sample carrier holding means (121) and by the second sample carrier holding means (131).

2. The holding device (100) according to claim 1, wherein the first sample carrier holding means (121) is formed by at least part of an inner wall (122) of the sample carrier receptacle.

3. The holding device (100) according to claim 1 or 2, wherein the at least one first sample carrier holding means (121) comprises at least one protrusion (123), the inner surface of which serves at least partially as a sample carrier contact surface (122a).

4. The holding device (100) according to any one of the preceding claims, wherein the at least one second sample carrier holding means (131) comprises a spring, in particular a leaf spring.

5. The holding device (100) according to any one of the preceding claims, wherein at least one second recess (141) is provided in the body (110), which recess is designed in such a way that a sample carrier (200) resting against the sample carrier support surface (150) can be gripped by means of a gripping tool (300).

6. The holding device (100) according to claim 5, wherein the at least one first sample carrier holding means (121) comprises at least two portions (121a, 121b) formed laterally of the second recess (141) in the body (110).

7. The holding device (100) according to any one of the preceding claims, which is formed in such a way that it extends in a direction perpendicular to the sample carrier receiving surface (150) in the direction of an abutting sample carrier (200) at most by a dimension corresponding to a thickness (d) of the sample carrier (200).

8. The holding device (100) according to one of the preceding claims, wherein the at least one sample carrier receptacle (155) is formed in such a way that the sample carrier (200), when it rests against the sample carrier support surface (150), rests with at least 10% of a surface facing the sample carrier support surface (150), and/or wherein the at least one sample carrier receptacle (155) is designed in such a way that a mount (210) of the sample carrier (200), when it bears against the sample carrier bearing surface (150), bears with at least 20% of a surface facing the sample carrier bearing surface (150).

9. The holding device (100) according to any one of the preceding claims, wherein the at least one second sample carrier holding means (131) is arranged to be pushed away from the at least one first sample carrier holding means (121) upon positioning of the sample carrier (200).

10. The holding device (100) according to any of the preceding claims, which is designed for use with annular sample carriers (200).

11. The holding device (100) according to one of the preceding claims, with at least two sample carrier receptacles (150).

12. The holding device (100) according to any of the preceding claims, the largest dimension of which is less than 50 mm, in particular less than 20 mm.

13. The holding device (100) according to any one of the preceding claims, wherein a receptacle (160) for a manipulator (430) for moving the holding device (100) is provided.

14. An arrangement comprising a manipulation container (400) and a holding device (100) according to claim 13, wherein the manipulation container (400) is designed in such a way that the holding device (100) can be fixed therein, and a manipulator (430) is provided onto which the holding device (100) can be placed and with which the holding device (100) can be moved.

15. A method of inserting a sample carrier (200) into a holding device (100) according to any one of claims 1 to 13,
wherein the sample carrier (200) is gripped by a gripping tool (300) and pressed against a second holding means (131) so that this second holding means (131) is pressed away from a first holding means (121), and
wherein the sample carrier (200) is then placed against the sample carrier support surface (150) and moved against the first holding means (121) until it reaches a stop thereon.

16. A method of extracting a sample carrier (200) from a holding device (100) according to any one of claims 1 to 13,
wherein the sample carrier (200) is moved away from a first holding means (121) by means of a gripping tool (300) while pressing against a second holding means (131), and
the sample carrier (200) is then lifted away from the sample carrier support surface (150) and removed from the holding device (100).

## Revendications

1. Dispositif de maintien (100) pour support d'échantillons (200) destiné à être utilisé en cryo-microscopie, comprenant
- un corps (110) avec au moins un logement de support d'échantillon (155), qui présente au moins une surface d'appui de support d'échantillon (150), sur laquelle peut être posé au moins un support d'échantillon (200),
- au moins un premier moyen de maintien de support d'échantillon (121), et
- au moins un deuxième moyen de maintien de support d'échantillon (131) qui est adapté pour appliquer une force au support d'échantillon (200) contre le premier moyen de maintien de support d'échantillon (121),
dans lequel le au moins un premier moyen de maintien de support d'échantillon (121) présente au moins un premier évidement (125), sous la forme d'une contre-dépouille, dans lequel le support d'échantillon (200) peut être partiellement inséré,
**caractérisé en ce que** le au moins un premier moyen de maintien de support d'échantillon (121) et le au moins un deuxième moyen de maintien de support d'échantillon (131) sont formés de telle sorte que le support d'échantillon (200), lorsqu'il est en appui contre le premier moyen de maintien de support d'échantillon (121) et contre le deuxième moyen de maintien de support d'échantillon (131), est pressé contre la surface de support de support d'échantillon (150) par le premier moyen de maintien de support d'échantillon (121) et par le deuxième moyen de maintien de support d'échantillon (131).

2. Le dispositif de maintien (100) selon la revendication 1, dans lequel le premier moyen de retenue de support d'échantillon (121) est formé par au moins une partie d'une paroi intérieure (122) du logement de support d'échantillon.

3. Le dispositif de maintien (100) selon la revendication 1 ou 2, dans lequel ledit au moins un premier moyen de maintien de support d'échantillon (121) comprend au moins une saillie (123) dont la surface intérieure sert au moins partiellement de surface d'appui de support d'échantillon (122a).

4. Le dispositif de maintien (100) selon l'une quelconque des revendications précédentes, dans lequel ledit au moins un deuxième moyen de maintien de support d'échantillon (131) comprend un ressort, en particulier un ressort à lame.

5. Le dispositif de maintien (100) selon l'une des revendications précédentes, dans lequel il est prévu dans le corps (110) au moins un deuxième évidement (141) qui est conçu de telle sorte qu'un support d'échantillon (200) reposant sur la surface d'appui (150) du support d'échantillon peut être saisi au moyen d'un outil de préhension (300).

6. Le dispositif de maintien (100) selon la revendication 5, dans lequel ledit au moins un premier moyen de retenue de support d'échantillon (121) comprend au moins deux parties (121a, 121b) formées latéralement au deuxième évidement (141) dans le corps (110).

7. Le dispositif de maintien (100) selon l'une des revendications précédentes, qui est conçu de telle sorte qu'il s'étend dans une direction perpendiculaire à la surface de réception (150) du porte-échantillon en direction d'un porte-échantillon (200) adjacent, au maximum d'une mesure correspondant à une épaisseur (d) du porte-échantillon (200).

8. Le dispositif de maintien (100) selon l'une des revendications précédentes, dans lequel le au moins un logement de support d'échantillon (155) est conçu de telle sorte que le support d'échantillon (200), lorsqu'il est en appui contre la surface d'appui de support d'échantillon (150), est en appui avec au moins 10%, , d'une surface orientée vers la surface d'appui de support d'échantillon (150), et/ou dans lequel l'au moins un logement de support d'échantillon (155) est conçu de telle sorte qu'une monture (210) du support d'échantillon (200), lorsqu'elle s'applique contre la surface d'appui de support d'échantillon (150), s'applique avec au moins 20% d'une surface tournée vers la surface d'appui de support d'échantillon (150).

9. Le dispositif de maintien (100) selon l'une quelconque des revendications précédentes, dans lequel ledit au moins un deuxième moyen de retenue de support d'échantillon (131) est adapté pour être pressé à l'écart dudit au moins un premier moyen de retenue de support d'échantillon (121) lors du positionnement du support d'échantillon (200).

10. Le dispositif de maintien (100) selon l'une quelconque des revendications précédentes, qui est conçu pour être utilisé avec des porte-échantillons annulaires (200).

11. Le dispositif de maintien (100) selon l'une quelconque des revendications précédentes, comprenant au moins deux logements de support d'échantillon (150).

12. Le dispositif de maintien (100) selon l'une des revendications précédentes, dont la plus grande dimension est inférieure à 50 mm, notamment inférieure à 20 mm.

13. Le dispositif de maintien (100) selon l'une des revendications précédentes, dans lequel un logement (160) pour un manipulateur (430) est prévu pour le déplacement du dispositif de maintien (100).

14. Agencement comprenant un récipient de manipulation (400) et un dispositif de maintien (100) selon la revendication 13, le récipient de manipulation (400) étant conçu de telle sorte que le dispositif de retenue (100) peut y être fixé, et un manipulateur (430) étant prévu, sur lequel le dispositif de retenue (100) peut être placé et avec lequel le dispositif de retenue (100) peut être déplacé.

15. Procédé de mise en place d'un support d'échantillon (200) dans un dispositif de maintien (100) selon l'une des revendications 1 à 13,
dans lequel le support d'échantillon (200) est saisi par un outil de préhension (300) et est pressé contre un second moyen de retenue (131) de sorte que ledit second moyen de retenue (131) est pressé à l'écart d'un premier moyen de retenue (121), et
le support d'échantillon (200) étant ensuite appliqué contre la surface d'appui (150) du support d'échantillon et déplacé contre le premier moyen de retenue (121) jusqu'à une butée sur celui-ci.

16. Procédé de sortie d'un support d'échantillon (200) d'un dispositif de maintien (100) selon l'une des revendications 1 à 13,
dans lequel le support d'échantillon (200) est éloigné d'un premier moyen de retenue (121) au moyen d'un outil de préhension (300) tout en étant pressé contre un deuxième moyen de retenue (131), et
le support d'échantillon (200) étant ensuite soulevé de la surface d'appui (150) du support d'échantillon et extrait du dispositif de maintien (100).
